# EUROPÄISCHE PATENTSCHRIFT

(11) **EP 2 513 120 B1**
(45) Veröffentlichungstag und Bekanntmachung des Hinweises auf die Patenterteilung: **30.08.2017**
(21) Anmeldenummer: 10726542.3
(22) Anmeldetag: 01.07.2010
(51) Int. Cl.: C07F 5/00, H01L 33/42

(54) **VERFAHREN ZUR HERSTELLUNG VON INDIUMCHLORDIALKOXIDEN**
METHOD OF PREPARATION OF INDIUMCHLORODIALKOXIDES
PROCÉDE POUR LA PREPARATION DES INDIUMCHLORODIALKOXIDES

(30) Priorität: 18.12.2009 DE 102009054998
(43) Veröffentlichungstag der Anmeldung: 24.10.2012
(73) Patentinhaber: Evonik Degussa GmbH, 45128 Essen (DE)
(72) Erfinder: STEIGER, Jürgen, 40237 Düsseldorf (DE); MERKULOV, Alexey, 67059 Ludwigshafen (DE); FRÜHLING, Dennis, 45768 Marl (DE); HOPPE, Arne, 44623 Herne (DE); BRAUSCH, Nicole, 45130 Essen (DE)
(86) Internationale Anmeldenummer: PCT/EP2010/059376
(87) Internationale Veröffentlichungsnummer: WO 2011/072887

(56) Entgegenhaltungen:
- JP-A- 1 115 010
- JP-A- 2 113 033
- JP-A- 2 145 459
- JP-A- 59 198 606
- JP-A- 59 198 607
- US-A- 4 681 959

## Beschreibung

Die vorliegende Erfindung betrifft ein Verfahren zur Herstellung von Indiumchlordialkoxiden, die mit dem erfindungsgemäßen Verfahren herstellbaren Indiumchlordialkoxide sowie deren Verwendung.

Die Herstellung halbleitender elektronischer Bauteilschichten über Druck- und andere flüssige Abscheidungsprozesse ermöglicht im Vergleich zu vielen anderen Verfahren, wie z.B. Chemical Vapor Deposition (CVD), weitaus niedrigere Produktionskosten, da die Deposition des Halbleiters hier in einem kontinuierlichen Prozess erfolgen kann. Darüber hinaus eröffnet sich im Falle niedrigerer Prozesstemperaturen die Möglichkeit, auch auf flexiblen Substraten zu arbeiten, und gegebenenfalls (vor allem im Falle sehr dünner Schichten und insbesondere bei oxidischen Halbleitern) eine optische Transparenz der gedruckten Schichten zu erreichen. Unter halbleitenden Schichten sind hier und im folgenden Schichten zu verstehen, die Ladungsträgerbeweglichkeiten von 1 bis 50 cm²/Vs bei einem Bauteil mit einer Kanallänge von 20 µm bei 50 V Gate-Source-Spannung und 50 V Source-Drain-Spannung aufweisen.

Da das Material der über Druckverfahren herzustellenden Bauteilschicht die jeweiligen Schichteigenschaften maßgeblich bestimmt, hat seine Wahl einen bedeutsamen Einfluss auf jedes diese Bauteilschicht enthaltende Bauteil. Wichtige Parameter für gedruckte Halbleiterschichten sind ihre jeweiligen Ladungsträgerbeweglichkeiten sowie die Verarbeitbarkeiten und Verarbeitungstemperaturen der bei ihrer Herstellung eingesetzten verdruckbaren Vorstufen. Die Materialien sollten eine gute Ladungsträgerbeweglichkeit aufweisen und aus Lösung und bei Temperaturen deutlich unter 500 °C herstellbar sein, um für eine Vielzahl von Anwendungen und Substraten geeignet zu sein. Ebenfalls wünschenswert für viele neuartige Anwendungen ist eine optische Transparenz der erzeugten halbleitenden Schichten.

Indiumoxid (Indium(III)oxid, In₂O₃) ist aufgrund der großen Bandlücke zwischen 3.6 und 3.75 eV (gemessen für aufgedampfte Schichten, H.S. Kim, P.D. Byrne, A. Facchetti, T.J. Marks; J. Am. Chem. Soc. 2008, 130, 12580-12581) ein vielversprechender und somit gerne eingesetzter Halbleiter. Dünne Filme von wenigen hundert Nanometern Dicke können darüber hinaus eine hohe Transparenz im sichtbaren Spektralbereich von größer als 90 % bei 550 nm aufweisen. In extrem hoch geordneten Indiumoxid-Einkristallen kann man zudem Ladungsträgerbeweglichkeiten von bis zu 160 cm²/Vs messen. Bislang können jedoch solche Werte durch Prozessierung aus Lösung noch nicht erreicht werden (H. Nakazawa, Y. Ito, E. Matsumoto, K. Adachi, N. Aoki, Y. Ochiai; J. Appl. Phys. 2006, 100, 093706. und A. Gupta, H. Cao, Parekh, K.K.V. Rao, A.R. Raju, U.V. Waghmare; J. Appl. Phys. 2007, 101, 09N513).

Indiumoxid wird oft vor allem zusammen mit Zinn(IV)-oxid (SnO₂) als halbleitendes Mischoxid ITO eingesetzt. Aufgrund der verhältnismäßig hohen Leitfähigkeit von ITO-Schichten bei gleichzeitiger Transparenz im sichtbaren Spektralbereich findet es unter anderem Anwendung im Bereich von Flüssigkristallbildschirmen (LCD; liquid crystal display), insbesondere als "durchsichtige Elektrode". Diese zumeist dotierten Metalloxid-Schichten werden industriell vor allem durch kostenintensive Aufdampfmethoden im Hochvakuum hergestellt. Aufgrund des großen wirtschaftlichen Interesses an ITO-beschichteten Substraten existieren mittlerweile einige, vor allem auf Sol-Gel-Techniken beruhende Beschichtungsverfahren für Indiumoxidhaltige Schichten.

Prinzipiell gibt es zwei Möglichkeiten für die Herstellung von Indiumoxid-Halbleitern über Druckverfahren: 1) Partikel-Konzepte, bei denen (Nano)Partikel in verdruckbarer Dispersion vorliegen und nach dem Druckvorgang durch Sintervorgänge in die gewünschte Halbleiterschicht konvertiert werden, sowie 2) Precursor-Konzepte, bei denen mindestens ein lösliches oder dispergierbares Vorprodukt nach dem Verdrucken einer entsprechenden Zusammensetzung zu einer Indiumoxid-haltigen Schicht umgesetzt wird. Das Partikelkonzept hat zwei bedeutende Nachteile gegenüber dem Einsatz von Precursoren: Zum einen weisen die Partikel-Dispersionen eine kolloidale Instabilität auf, die die Anwendung von (in Bezug auf die späteren Schichteigenschaften nachteiligen) Dispergieradditiven erforderlich macht, zum anderen bilden viele der einsetzbaren Partikel (z.B. aufgrund von Passivierungsschichten) nur unvollständig Schichten durch Sinterung aus, so dass in den Schichten teilweise noch partikuläre Strukturen vorkommen. An deren Partikelgrenze kommt es zu einem erheblichen Partikel-Partikel-Widerstand, welcher die Beweglichkeit der Ladungsträger verringert und den allgemeinen Schichtwiderstand erhöht.

Es gibt verschiedene Precursoren für die Herstellung von Indiumoxid-Schichten. So können neben Indiumsalzen Indium-Alkoxide (homoleptische, d.h. nur Indium und Alkoxid-Reste aufweisende Verbindungen) als Precursoren für die Herstellung von Indiumoxid-haltigen Schichten eingesetzt werden.

Zum Beispiel beschreiben Marks et al. Bauteile, bei deren Herstellung eine Precursor-haltige Zusammensetzung umfassend das Salz InCl₃ sowie der Base Monoethanolamin (MEA) gelöst in Methoxyethanol eingesetzt wird. Nach Aufschleudern (Spin-coating) der Zusammensetzung wird die entsprechende Indiumoxid-Schicht durch eine thermische Behandlung bei 400 °C erzeugt (H.S. Kim, P.D. Byrne, A. Facchetti, T.J. Marks; J. Am. Chem. Soc. 2008, 130, 12580-12581 and supplemental informations).

Gegenüber Indiumsalz-haltigen Zusammensetzungen bieten Indiumalkoxid-haltige Zusammensetzungen den Vorteil, dass sie bei geringeren Temperaturen zu Indiumoxid-haltigen Beschichtungen umgewandelt werden können. Weiterhin wurde bislang davon ausgegangen, dass halogenhaltige Precursoren potentiell den Nachteil haben, zu halogenhaltigen Schichten mit verminderter Qualität zu führen. Aus diesem Grund wurden in der Vergangenheit Versuche zur Schichtbildung mit Indiumalkoxiden vorgenommen.

Indium-Alkoxide und ihre Synthese sind bereits seit den siebziger Jahren des vorigen Jahrhunderts beschrieben.

So fassen zum Beispiel Carmalt et al. in einem Review-Artikel die zu diesem Zeitpunkt bekannten Daten zu Synthese, Struktur und Reaktivitäten von u.a. Indium(III)alkoxiden und - alkylalkoxiden zusammen (Carmalt et al., Coord. Chem Rev. 250 (2006), 682 - 709).

Eine der am längsten bekannten Synthesen von Indiumalkoxiden beschreiben Chatterjee et al. Sie beschreiben die Herstellung von Indiumtrisalkoxid In(OR)₃ aus Indium(III)chlorid (InCl₃) mit Natriumalkoxid Na-OR, wobei R für-Methyl, -Ethyl, iso-Propyl, n-, s-, t-Butyl und -Pentyl Reste steht (S. Chatterjee, S. R. Bindal, R.C. Mehrotra; J. Indian Chem. Soc.1976, 53, 867).

Bradley et al. berichten von einer ähnlichen Reaktion wie Chatterjee et al. und erhalten bei annähernd identischen Edukten (InCl₃, Isopropyl-Natrium) und Reaktionsbedingungen einen Indium-Oxo-Cluster mit Sauerstoff als Zentralatom (D.C. Bradley, H. Chudzynska, D.M. Frigo, M.E. Hammond, M.B. Hursthouse, M.A. Mazid; Polyhedron 1990, 9, 719).

Eine besonders gute Variante dieses Verfahrens, die zu einer besonders niedrigen Verunreinigung an Chlor im Produkt führt, wird in US 2009-0112012 A1 beschrieben. Die Bestrebungen, einen möglichst niedrigen Grad an Chlor-Verunreinigungen im Produkt zu erreichen, werden dabei darauf zurückgeführt, dass bislang davon ausgegangen wurde, dass Chlor-Verunreinigungen zu einer Verminderung der Performance oder der Lebensdauer elektronischer Bauteile beitragen (vergleiche zum Beispiel US 6,426,425 B2).

Ebenfalls auf einem Indiumhalogenid, jedoch auf anderen Basen, basiert das in US 5,237,081 A beschriebene Verfahren zur Herstellung reiner Indiumalkoxide, bei denen ein Indium(III)halogenid in einem basischen Medium mit einem Alkohol umgesetzt wird. Die Base soll eine starke Base mit niedriger Nucleophilie sein. Beispielhaft genannte Basen sind neben exemplarisch genannten komplexen cyclischen Heterocyclen tertiäre Amine.

US 4,681,959 A beschreibt ein allgemeines zweistufiges Verfahren zur Herstellung von Metallalkoxiden (insbesondere Tetraalkoxyverbindungen wie Tetramethyltitanat), bei dem ein Halogenid eines mindestens zweiwertigen Metalls mit einem Alkohol ggf. in Gegenwart eines aromatischen Lösemittels zunächst zu einem Zwischenprodukt (einer Halogen-Alkoxy-Verbindung des Metalls) umgesetzt wird. Anschließend wird das Zwischenprodukt mit einem Alkohol in Gegenwart eines Wasserstoffhalogenid-Akzeptors (insbesondere einem tertiären Amin) unter Bildung des Metallalkoxids umgesetzt.

Alternative Syntheserouten zu homoleptischen Indiumalkoxid-Komplexen werden von Seigi Suh et al. in J. Am. Chem. Soc. 2000, 122, 9396 - 9404 beschrieben. Die dort beschriebenen Verfahren sind jedoch sehr aufwändig und/oder basieren auf nicht kommerziell erhältlichen (und somit erst nachteilig in einem vorgelagerten Schritt zu synthetisierenden) Edukten.

Überraschenderweise wurde nun festgestellt, dass die bisherige Annahme, dass chlorhaltige Precursoren zwangsläufig zu nachteiligen Schichten führen, nicht immer zutrifft. So resultieren bei einem Precursor-basierten Verfahren, bei dem eine flüssige Precursor-Zusammensetzung auf ein Substrat aufgebracht wird und der Beschichtungsfilm vor einer thermischen Konvertierung zunächst mit UV-Strahlung behandelt wird, im Falle der Verwendung von Indiumchlordialkoxiden anstelle von Indiumalkoxiden sogar bessere Schichten, da diese bessere elektrische Eigenschaften, insbesondere höhere Feldeffektbeweglichkeiten µ_{FET} aufweisen. Somit sind Verfahren zur Synthese von Indiumchlordialkoxiden von großem Interesse.

Ein allgemeines Verfahren zur Herstellung von Halogen-Alkoxy-Metall-Verbindungen ist in US 4,681,959 A beschrieben: Dort wird allgemein ein zweistufiges Verfahren zur Herstellung von Metallalkoxiden (insbesondere von Tetraalkoxyverbindungen wie Tetramethyltitanat) beschrieben, bei dem ein Halogenid eines mindestens zweiwertigen Metalls mit einem Alkohol - ggf. in Gegenwart eines aromatischen Lösemittels - zunächst zu einem Zwischenprodukt (einer Halogen-Alkoxy-Verbindung des Metalls) umgesetzt wird. Bevorzugt wird dabei entstehender Halogenwasserstoff mit einem Inertgas wie z.B. Stickstoff ausgetrieben. Das dort beschriebene Verfahren hat jedoch den Nachteil, dass im Falle, dass Indiumhalogenide als Edukte eingesetzt werden, die Umsetzung mit Alkohol sehr langsam verläuft bzw. nach der Bildung von Addukten des Typs InCl₃(ROH)ₓ endet.

Indiumhalogenalkoxide und ihre Synthese sind in JP 02-113033 A und JP 02-145459 A beschrieben. So offenbart JP 02-113033 A, dass chlorhaltige Alkoxide von Indium nach Lösung von Indiumchlorid in einem dem einzubauenden Alkoxidrest entsprechenden Alkohol durch nachfolgende Zugabe eines bestimmten Anteils eines Alkalimetalls oder einer Alkalimetallalkoxids hergestellt werden können. Ein entsprechendes Verfahren beschreibt auch JP 02-145459 A. Nachteilig bei diesen Verfahren sind jedoch die möglichen Verunreinigungen der entstehenden Indiumchloralkoxide mit Natrium.

Es ist somit die Aufgabe der vorliegenden Erfindung, Verfahren zur Synthese von Indiumchlordialkoxiden bereitzustellen, die die Nachteile des Standes der Technik, insbesondere die langsamen Reaktionsgeschwindigkeiten und die entstehenden Verunreinigungen bei der Synthese vermeiden.

Diese Aufgabe wird überraschenderweise gelöst durch das erfindungsgemäße Verfahren zur Herstellung von Indium(III)halogendialkoxiden der generischen Formel InX(OR)₂ mit X = F, Cl, Br, I und R = Alkylrest, Alkyloxyalkylrest, bei dem eine Zusammensetzung (A) umfassend ein Indiumtrihalogenid InX₃ mit X = F, Cl, Br und/oder I und mindestens einen Alkohol der generischen Formel ROH mit R = Alkylrest, Oxyalkylrest mit einer Zusammensetzung (B) umfassend mindestens ein sekundäres Amin der generischen Formel R'₂NH mit R' = Alkylrest umgesetzt wird.

Unter einem Alkyl- bzw. Alkyloxyalkylrest R ist dabei bevorzugt eine C1- bis C15-Alkyl- oder Alkyloxyalkylgruppe, d.h. eine Alkyl- oder Alkyloxyalkylgruppe mit insgesamt 1 - 15 Kohlenstoffatomen, zu verstehen. Bevorzugt handelt es sich um einen Alkyl- bzw. Alkyloxyalkylrest R ausgewählt aus -CH₃, -CH₂CH₃, -CH₂CH₂OCH₃, -CH(CH₃)₂ oder -C(CH₃)₃. Eingesetzt werden können im Prinzip alle Indiumtrihalogenide InX₃. Bei diesen kann X jeweils unabhängig voneinander F, Cl, Br und/oder I sein. Bevorzugt werden jedoch Indiumtrihalogenide nur eines Halogenids, d.h. die Indiumtrihalogenide InF₃, InCl₃, InBr₃, oder Inl₃, eingesetzt. Aufgrund ihrer leichten Zugänglichkeit ist die Verwendung der Indiumtrihalogenide InCl₃ und InBr₃ besonders bevorzugt.

Das Indiumtrihalogenid InX₃ wird bevorzugt in Anteilen von 0,1 bis 50 Gew.-%, besonders bevorzugt 1 bis 25 Gew.-%, ganz besonders bevorzugt 2 bis 10 Gew.-% bezogen auf die Gesamtmasse der Zusammensetzung (A) eingesetzt.

Die Zusammensetzung (A) umfassend das Indiumtrihalogenid kann dieses gelöst, d.h. dissoziiert bzw. auf molekularer Ebene komplexiert mit Lösemittelmolekülen/Alkoholmolekülen, oder in flüssiger Phase dispergiert aufweisen.

Die Zusammensetzung (A) weist weiterhin mindestens einen Alkohol der generischen Formel ROH mit R = Alkyl- bzw. Alkyloxyalkylrest auf. Somit kann die Zusammensetzung auch zwei oder mehr Alkohole aufweisen. Zur bevorzugten Erzeugung von Indium(III)halogendialkoxiden von einer spezifischen Art von Alkoxiden sollte jedoch nur ein Alkohol in der Zusammensetzung (A) vorliegen.

Bevorzugt einsetzbare Alkohole weisen Reste R ausgewählt aus C1- bis C15-Alkyl- oder - Alkyloxyalkylresten, d.h. Alkyl- oder Alkyloxyalkylgruppen mit insgesamt 1 - 15 Kohlenstoffatomen, auf. Bevorzugt werden Alkohole mit einem Alkyl- bzw. Alkyloxyalkylrest R ausgewählt aus -CH₃, -CH₂CH₃, -CH₂CH₂OCH₃, -CH(CH₃)₂ oder -C(CH₃)₃ eingesetzt.

Der Alkohol ROH wird bevorzugt in Anteilen von 50 bis 99,9 Gew.-%, besonders bevorzugt 75 bis 99 Gew.-%, ganz besonders bevorzugt 80 bis 96 Gew.-% bezogen auf die Gesamtmasse der Zusammensetzung (A) eingesetzt.

Die Zusammensetzung (A) kann weiterhin mindestens ein in Bezug auf die Reaktion inertes flüssiges Lösemittel bzw. Dispersionsmedium, d.h. ein Lösemittel/Dispersionsmedium oder ein Gemisch verschiedener Lösemittel/Dispersionsmedien, die unter den Reaktionsbedingungen nicht mit InX₃ reagieren, aufweisen. Vorzugsweise einsetzbar sind aprotische Lösemittel, insbesondere solche ausgewählt aus der Gruppe der aprotischen unpolaren Lösemittel, d.h. der Alkane, substituierten Alkane, Alkene, Alkine, Aromaten ohne oder mit aliphatischen oder aromatischen Substituenten, halogenierten Kohlenwasserstoffe und Tetramethylsilan, und der Gruppe der aprotischen polaren Lösemittel, d.h. der Ether, aromatischen Ether, substituierten Ether, Ester oder Säureanhydride, Ketone, tertiäre Amine, Nitromethan, DMF (Dimethylformamid), DMSO (Dimethylsulfoxid) oder Propylencarbonat.

Liegt mindestens ein solches in Bezug auf die Reaktion inertes flüssiges Lösemittel bzw. Dispersionsmedium in der Zusammensetzung (A) vor, beträgt sein Anteil an der Zusammensetzung bevorzugt 1 bis 50 Gew.-%, besonders bevorzugt 1 bis 25 Gew.-%, ganz besonders bevorzugt 1 bis 10 Gew.-% bezogen auf die Gesamtmasse der Zusammensetzung.

Erfindungsgemäß wird die Zusammenfassung (A) umfassend InX₃ zur Synthese der Indium(III)halogendialkoxide weiterhin mit einer Zusammensetzung (B) umfassend mindestens ein sekundäres Amin der generischen Formel R'₂NH mit R' = Alkylrest umgesetzt. Bevorzugt handelt es sich bei dem mindestens einen sekundären Amin der generischen Formel R'₂NH um ein sekundäres Amin mit Resten R' unabhängig voneinander ausgewählt aus der Gruppe bestehend aus C₁-C₁₀-Alkylresten. Bevorzugt wird nur ein sekundäres Amin eingesetzt. Weiter bevorzugt weist das sekundäre Amin als Reste R' den gleichen Alkylrest auf. Besonders bevorzugte Reste R' sind lineare C₁-C₁₀-Alkylreste. Besonders gute Ergebnisse werden mit Resten R' = Methyl, Ethyl und n-Propyl erreicht. Ganz besonders gute Ergebnisse resultieren, wenn ein sekundäres Amin der generischen Formel R'₂NH mit R = Methyl eingesetzt wird, da dies in den bevorzugt eingesetzten Lösemitteln bzw. Dispersionsmedien besonders gut löslich ist und somit zu besonders guten Ausbeuten führt.

Das mindestens eine sekundäre Amin wird zur Erzielung besonders guter Ausbeuten im Wesentlichen mindestens doppelt stöchiometrisch in Bezug auf das Indiumtrihalogenid InX₃ zugegeben. Besonders bevorzugt wird das sekundäre Amin in einer Menge, die der 4- bis 6-fachen molaren Menge von InX₃ entspricht, eingesetzt.

Zur Erzielung erhöhter Produktausbeuten kann das sekundäre Amin nicht nur in Lösung, sondern bevorzugt dispergiert in einem Dispersionsmedium eingesetzt werden. Die Zusammensetzung (B) kann jedoch für eine besonders einfache Reaktionsführung ausschließlich aus dem sekundären Amin bestehen.

Bevorzugt wird die Reaktion bei einer Temperatur im Bereich von 25 °C - 250 °C durchgeführt. Besonders bevorzugt wird die Reaktion bei einer Temperatur im Bereich von 25 °C bis zu der Temperatur, die dem Siedepunkt des eingesetzten Alkohols entspricht, eingesetzt. Somit liegt die Temperatur besonders bevorzugt im Bereich von 25 °C und 125 °C.

Die Synthese kann prinzipiell bei Normdruck oder bei erhöhtem Druck erfolgen. Bevorzugt wird die Synthese jedoch bei Normdruck (1013 mbar) durchgeführt.

Bevorzugt erfolgt die Synthese weiterhin wasserfrei, d.h. in Anwesenheit von maximal 200 ppm H₂O. Zur Erzielung besonders guter Ausbeuten sollte die Reaktion weiterhin in einer Inertgasatmosphäre, bevorzugt in einer Ar, He oder N₂-Atmosphäre, ganz besonders bevorzugt in einer N₂-Atmosphäre durchgeführt werden.

Zur Erzielung besonders hoher Ausbeuten wird das Reaktionsgemisch weiterhin vor Aufarbeitung auf eine Temperatur im Bereich von 10 - 20 °C abgekühlt.

Bevorzugt kann die Aufreinigung durch Eindampfen des Reaktionsgemisches, Aufnehmen des Rückstandes in dem eingesetzten Alkohol, Filtration und Waschen erfolgen. Anschließend kann das Produkt bevorzugt im Hochvakuum getrocknet werden.

Gegenstand der Erfindung sind weiterhin die über das erfindungsgemäße Verfahren herstellbaren Indium(III)halogendialkoxide. Diese weisen die Summenformel InX(OR)₂ auf, können jedoch weiterhin im Kristall oder in der wässrigen Phase mit aus der Synthese stammendem Alkohol ROH bzw. sekundärem Amin R'₂NH koordiniert bzw. solvatisiert sein.

Die nach dem erfindungsgemäßen Verfahren herstellbaren Indium(III)halogendialkoxide eignen sich vorteilhaft zur Herstellung Indiumoxid-haltiger Beschichtungen, insbesondere über nasschemische Verfahren. Unter Indiumoxid-haltigen Beschichtungen sind in diesem Falle sowohl Indiumoxid-Schichten als auch Schichten im Wesentlichen umfassend Indiumoxid und weitere Metalle und/oder Metalloxide zu verstehen. Unter einer Indiumoxid-Schicht im Sinne der vorliegenden Erfindung ist dabei eine aus den erwähnten Indiumalkoxiden herstellbare, metallhaltige Schicht zu verstehen, die im Wesentlichen Indiumatome bzw. -ionen aufweist, wobei die Indiumatome bzw. -ionen im Wesentlichen oxidisch vorliegen. Gegebenenfalls kann die Indiumoxid-Schicht auch noch Halogen-, Carben- bzw. Alkoxid-Anteile aus einer nicht vollständigen Konvertierung aufweisen. Entsprechendes gilt auch für Schichten im Wesentlichen umfassend Indiumoxid und weitere Metalle und/oder Metalloxide, mit der Maßgabe, dass diese weiterhin die weiteren Metalle und/oder Metalloxide aufweist.

Die mit dem erfindungsgemäßen Verfahren herstellbaren Indium(III)halogendialkoxide haben weiterhin den überraschenden Vorteil, dass diese besonders gut für die Herstellung halbleitender Indiumoxid-haltiger Beschichtungen eingesetzt werden können. Die über das erfindungsgemäße Verfahren herstellbaren Indium(III)halogendialkoxide eignen sich insofern weiterhin vorteilhaft für die Herstellung halbleitender oder leitender Schichten für elektronische Bauteile, insbesondere die Herstellung von (Dünnschicht)Transistoren, Dioden oder Solarzellen.

Das nachfolgende Beispiel soll den Gegenstand der vorliegenden Erfindung weiter erläutern, ohne selbst beschränkend zu wirken.

### Beispiel

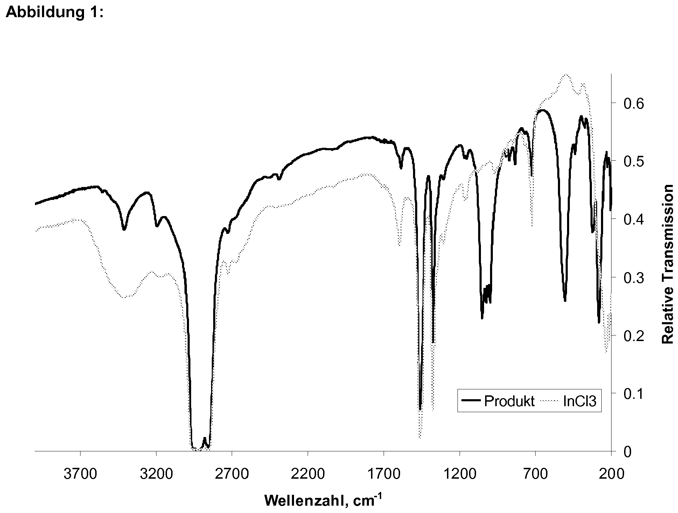

In einem von Restfeuchte befreiten 500 ml-Glasrundkolben werden 5,0 g Indium(III)chlorid (InCl₃, 22,5 mmol) unter Schutzgasatmosphäre durch Rühren in 250 ml getrocknetem Methanol gelöst, wobei ein Rückstand an InCl₃ von < 10 Gew.-% (bzgl. der Einwaage) zurückbleibt. Die Dosierung der Base Dimethylamin (5,0 g entsprechend 111 mmol) wird über einen Massflow-Controller sichergestellt und in der stöchiometrischen Menge bzgl. InCl₃ bei Raumtemperatur über einen Zeitraum von fünf Stunden zugegeben, wobei eine leicht exotherme Reaktion am Anfang beobachtet wurde. Anschließend wird die Lösung vollständig verdampft, der zurückbleibende Feststoff mit 250 ml getrocknetem Methanol aufgenommen, unter Schutzgas N₂ filtriert, mehrfach (> 10 Vorgänge) mit getrocknetem Methanol gewaschen und unter Vakuum (< 10 mbar) für 12 h bei Raumtemperatur getrocknet. Die Produktausbeute betrug > 80 mol-% an Indium(III)chlordimethoxid (Indiumgehalt ermittelt via ICP-OES, Chlorgehalt ermittelt argentometrisch, Gehalt an Kohlenstoff und Wasserstoff ermittelt via Verbrennungsanalyse). Abbildung 1 zeigt ein IR-Spektrum des Produktes und des eingesetzten Eduktes InCl₃.

## Patentansprüche

1. Verfahren zur Herstellung von Indium(III)halogendialkoxiden der generischen Formel
**InX(OR)₂**
mit X = F, Cl, Br, I und R = Alkylrest, Alkyloxyalkylrest,
bei dem eine Zusammensetzung (A) umfassend
- ein Indiumtrihalogenid InX₃ mit X = F, Cl, Br und/oder I und
- mindestens einen Alkohol der generischen Formel ROH mit R = Alkylrest, Alkyloxyalkylrest
mit einer Zusammensetzung (B) umfassend mindestens ein sekundäres Amin der generischen Formel R'₂NH mit R' = Alkylrest umgesetzt wird.

2. Verfahren nach Anspruch 1,
**dadurch gekennzeichnet,**
**dass** das Indiumtrihalogenid ausgewählt aus der Gruppe bestehend aus InF₃, InCl₃, InBr₃ und InI₃ ist.

3. Verfahren nach Anspruch 1 oder 2,
**dadurch gekennzeichnet,**
**dass** das Indiumtrihalogenid InX₃ in Anteilen von 0,1 bis 50 Gew.-% bezogen auf die Gesamtmasse der Zusammensetzung (A) eingesetzt wird.

4. Verfahren nach einem der vorhergehenden Ansprüche,
**dadurch gekennzeichnet,**
**dass** der Alkohol ROH einen Rest R ausgewählt aus C1- bis C15-Alkyl- oder-Alkyloxyalkylresten aufweist.

5. Verfahren einem der vorhergehenden Ansprüche,
**dadurch gekennzeichnet,**
**dass** der Alkohol ROH in Anteilen von 50 - 99,9 Gew.-% bezogen auf die Gesamtmasse der Zusammensetzung (A) eingesetzt wird.

6. Verfahren nach einem der vorhergehenden Ansprüche,
**dadurch gekennzeichnet,**
**dass** die Zusammensetzung (A) weiterhin mindestens ein in Bezug auf die Reaktion inertes flüssiges Lösemittel bzw. Dispersionsmedium aufweist.

7. Verfahren nach einem der vorhergehenden Ansprüche,
**dadurch gekennzeichnet,**
**dass** das sekundäre Amin der generischen Formel R'₂NH ein sekundäres Amin mit Resten R' ausgewählt aus der Gruppe bestehend aus C₁-C₁₀-Alkylresten ist.

8. Verfahren nach einem der vorhergehenden Ansprüche,
**dadurch gekennzeichnet,**
**dass** das sekundäre Amin der generischen Formel R'₂NH mindestens doppelt stöchiometrisch in Bezug auf das Indiumtrihalogenid eingesetzt wird.

## Claims

1. A process for the preparation of an indium (III) halodialkoxide of the generic formula
**InX (OR)**₂
where X = F, Cl, Br, I and R = alkyl radical, alkyloxyalkyl radical,
in which a composition (A) comprising
- an indium trihalide InX₃, where X = F, Cl, Br and/or I, and
- at least one alcohol of the generic formula ROH, where R = alkyl radical, alkyloxyalkyl radical,
is reacted with a composition (B) comprising at least one secondary amine of the generic formula R'₂NH, where R' = alkyl radical.

2. A process according to claim 1,
**characterized in that**
the indium trihalide is selected from the group consisting of InF₃, InCl₃, InBr₃ and InI₃.

3. A process according to claim 1 or 2,
**characterized in that**
the indium trihalide InX₃ is used in proportions of 0.1 to 50% by weight, based on the total mass of the composition (A).

4. A process according to any one of the preceding claims,
**characterized in that**
the alcohol ROH has a radical R selected from C1- to C15-alkyl or -alkoxyalkyl radicals.

5. A process any one of the preceding claims,
**characterized in that**
the alcohol ROH is used in proportions of 50 - 99.9% by weight, based on the total mass of the composition (A).

6. A process according to any one of the preceding claims,
**characterized in that**
the composition (A) furthermore has at least one liquid solvent or dispersing medium which is inert with respect to the reaction.

7. A process according to any one of the preceding claims,
**characterized in that**
the secondary amine of the generic formula R'₂NH is a secondary amine having radicals R' selected from the group consisting of C₁-C₁₀-alkyl radicals.

8. A process according to any one of the preceding claims,
**characterized in that**
the secondary amine of the generic formula R'₂NH is used in at least twice the stochiometric amount relative to the indium trihalide.

## Revendications

1. Procédé pour la préparation d'halogénodialcoxydes d'indium (III) de formule générique
InX(OR)₂
dans laquelle X = F, Cl, Br, I et R = un radical alkyle, un radical alkyloxyalkyle, dans lequel une composition (A) comprenant
- un trihalogénure d'indium InX₃ dans lequel X = F, Cl, Br et/ou I et
- au moins un alcool de formule générique ROH dans laquelle R = un radical alkyle, un radical alkyloxyalkyle
est transformée avec une composition (B) comprenant au moins une amine secondaire de formule générique R'₂NH dans laquelle R' = un radical alkyle.

2. Procédé selon la revendication 1, **caractérisé en ce que** le trihalogénure d'indium est choisi dans le groupe constitué par InF₃, InCl₃, InBr₃ et InI₃.

3. Procédé selon la revendication 1 ou 2, **caractérisé en ce que** le trihalogénure d'indium InX₃ est utilisé en des proportions de 0,1 à 50% en poids par rapport à la masse totale de la composition (A).

4. Procédé selon l'une quelconque des revendications précédentes, **caractérisé en ce que** l'alcool ROH présente un radical R choisi parmi les radicaux C₁-C₁₅-alkyle ou C₁-C₁₅-alkyloxyalkyle.

5. Procédé l'une quelconque des revendications précédentes, **caractérisé en ce que** l'alcool ROH est utilisé en des proportions de 50-99,9% en poids par rapport à la masse totale de la composition (A).

6. Procédé selon l'une quelconque des revendications précédentes, **caractérisé en ce que** la composition (A) présente en outre au moins un solvant ou milieu de dispersion liquide, inerte par rapport à la réaction.

7. Procédé selon l'une quelconque des revendications précédentes, **caractérisé en ce que** l'amine secondaire de formule générique R'₂NH est une amine secondaire présentant des radicaux R' choisis dans le groupe constitué par les radicaux C₁-C₁₀-alkyle.

8. Procédé selon l'une quelconque des revendications précédentes, **caractérisé en ce que** l'amine secondaire de formule générique R'₂NH est utilisée en une quantité au moins double de la quantité stoechiométrique par rapport au trihalogénure d'indium.
